# EUROPEAN PATENT SPECIFICATION

(11) **EP 1 916 662 B1**
(45) Date of publication and mention of the grant of the patent: **13.07.2011**
(21) Application number: 07020832.7
(22) Date of filing: 24.10.2007
(51) Int. Cl.: G11B 33/02

(54) **Information reproducing apparatus**
Informationswiedergabevorrichtung
Appareil de reproduction d'informations

(30) Priority: 25.10.2006 JP 2006008703 U
(43) Date of publication of application: 30.04.2008
(73) Proprietor: Funai Electric Co., Ltd., Daito-shi, Osaka 574-0013 (JP)
(72) Inventor: Yoshida, Kazuyoshi, Daito-shi Osaka 574-0013 (JP)
(74) Representative: Grünecker, Kinkeldey, Stockmair & Schwanhäusser Anwaltssozietät

(56) References cited:
- EP-A1- 1 619 684
- US-A- 5 301 178
- US-A1- 2006 037 768

## Description

### BACKGROUND OF THE INVENTION

### 1. Field of the Invention

The present invention relates to an information reproducing apparatus provided with a front panel which is attached to a chassis as it is known from EP 1619 684.

### 2. Description of the Related Art

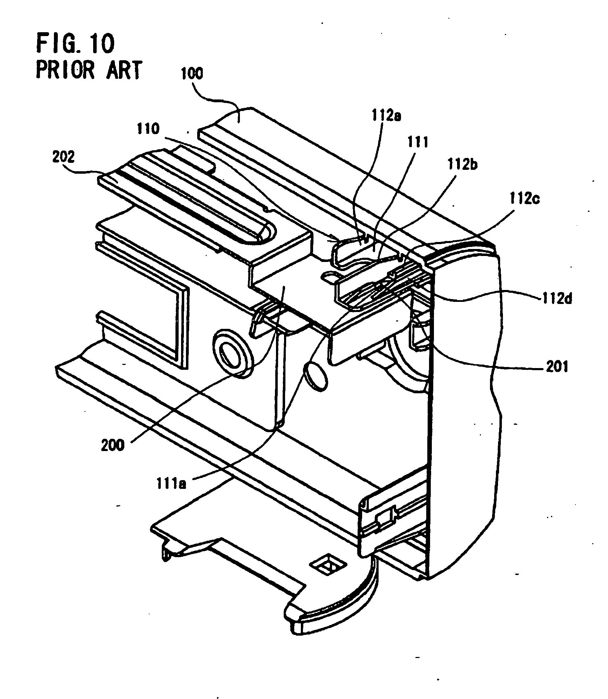

Conventionally, there is a known front panel which has a configuration shown in FIG 10 as a front panel of an information reproducing apparatus which can reproduce data such audios and videos stored in a record medium such as DVD. A front panel 100 is attached to a chassis 200 in the information reproducing apparatus. The front panel 100 has a hook portion 110 which extends inward of the information reproducing apparatus. The chassis 200 has an engaging pawl 201 with which the hook portion 110 engages. The engaging pawl 201 projects upward. The chassis 200 has a top cover supporting portion 202 which is formed by bending the chassis 200 to be one step higher than the area near the engaging pawl 201 to support a top cover (not shown) which covers the chassis 200.

The above hook portion 110 is made up of a_platy projecting portion 111 which has an engaging hole 111 a into which the engaging pawl 201 is inserted from below, ribs 112a and 112d formed on both-ends of the projecting portion 111, and ribs 112b and 112c formed between the ribs 112a and 112d on the both ends of the projecting portion 111 on an upper surface side of the projecting portion 111. A thickness of the projecting portion 111 is thin enough to bend. The ribs 112 reinforce the projecting portion 111. A tip of a bottom surface of the projecting portion 111 is formed in a tapered shape so that the hook portion 110 can be engaged with the engaging pawl 201 easily.

However, in the conventional front panel of the information reproducing apparatus, as shown in FIG. 10, the hook portion 110 and the chassis 200 are located close to each other when the engaging hole 111a in the hook portion 110 is engaged with the engaging pawl 201, thus it is hard to put in a tip of a finger between them, so that it is hard to detach the hook portion 110 from the engaging pawl 201, and thereby it is hard to detach the front panel 100 from the chassis 200. Moreover, the tip of the bottom surface of the projecting portion 111 is formed in the tapered shape, however, the thickness of the projecting portion 111 is thin enough to bend, thus it is hard to hook the tip of the finger on the tapered tip.
Consequently, it is hard to detach the hook portion 110 from the engaging pawl 201. Moreover, when the rib 112a on the left side in FIG. 10 and the top cover supporting portion 202 are located close to each other and also when there is a not gap wide enough to put in the finger between them, it is hard to pinch the ribs 112a and 112d on the both ends of the projecting portion 111 with the tip of the fingers and detach the hook portion 110 from the engaging pawl 201. Consequently, it is hard to detach the front panel 100 from the chassis 200.

### SUMMARY OF THE INVENTION

An object of the present invention is to provide an information reproducing apparatus provided with a front panel which can be easily detached from a chassis.

According to a first aspect of the present invention, this object is achieved by an information reproducing apparatus comprising: a chassis which has an engaging pawl which projects upward; and a front panel which is attached to a front surface of the chassis.

The front panel has a hook portion with which the engaging pawl is engaged.

The hook portion includes a projecting portion which has an engaging hole into which the engaging pawl is inserted from below, and ribs which are formed on both ends of the projecting portion and between the both ends of the projecting portion on an upper surface side of the projecting portion.

The information reproducing apparatus is characterised in that the hook portion has a finger hook portion which is provided on an upper end of the rib which is formed between the both ends of the projecting portion and extends in a direction toward both laterals of the projecting portion to hook tips of fingers.

With the above configuration, in the case where the engaging pawl in the chassis is engaged with the engaging hole in the hook portion on the front panel, the front panel can easily be detached from the chassis when the user hooks the tips of the fingers on the finger hook portion in the hook portion and subsequently pinches and picks up the finger hook portion.

According to a second aspect of the present invention, this object is achieved by an information reproducing apparatus comprising: a chassis which includes a bottom plate, supporting members which extend perpendicularly from both ends of a front end portion in the bottom plate, and a horizontal plate which is disposed between the supporting members and is supported by the supporting members; and a front panel which is attached to a front surface of the chassis.

An attaching frame in the chassis to attach the front panel is made up of at least a front end portion in the bottom plate, the supporting members, and the horizontal plate.

The horizontal plate in the chassis is made up of a sheet metal member which has an engaging pawl which projects upward.

The front panel has a hook portion which extends horizontally inward of the information reproducing apparatus and with which the engaging pawl is engaged.

The hook portion includes a platy projecting portion which has an engaging hole into which the engaging pawl is inserted from below, and ribs which are formed on both ends of the projecting portion and between the both ends of the projecting portion on an upper surface side of the projecting portion.

The information reproducing apparatus is characterised in that the hook portion has a finger hook portion which is provided on an upper end of the rib which is formed between the both ends of the projecting portion, extends in a direction toward both laterals of the projecting portion horizontally, has a thickness substantially the same as a width of the rib to hook tips of fingers, and has a width narrower than that of the projecting portion.

With the above configuration, in the case where the engaging pawl on the horizontal plate in the chassis is engaged with the engaging hole in the hook portion on the front panel, the front panel can easily be detached from the chassis when the user hooks tips of fingers on the finger hook portion in the hook portion and subsequently pinches and picks up the finger hook portion. Moreover, the finger hook portion is provided on the upper end of the rib which is formed between the both ends of the projecting portion and has the width narrower than the projecting portion, so that the user can pinch the finger hook portion without being interfered by the members which is located close to the lateral of the hook portion. Consequently, the front panel can easily be detached from the chassis. Moreover, the thickness of the finger hook portion is substantially the same as the width of the rib, thus the occurrence of the surface sink on the finger hook portion or the rib during the formation of the front panel can be avoided.

### BRIEF DESCRIPTION OF THE DRAWINGS

The present invention will be described below with reference to the annexed drawings. It is to be noted that all the drawings are shown for the purpose of illustrating the technical concept of the present invention or embodiments thereof, wherein:
FIG. 1 is a configuration diagram of an information reproducing apparatus according to a preferred embodiment of the present invention;
FIG. 2 is a perspective view of a front surface of a front panel in the information reproducing apparatus in FIG. 1;
FIG. 3 is a perspective view of a back surface of the front panel in FIG. 2;
FIG. 4 is an enlarged perspective view of a portion A framed by a dashed line in FIG. 3;
FIG. 5 is a perspective view of an appearance before engaging a hook portion of the front panel in FIG. 2 with a horizontal plate of a chassis in the information reproducing apparatus in FIG. 1;
FIG. 6 is a perspective view of an appearance after engaging a hook portion of the front panel in FIG. 2 with the horizontal plate of the chassis in FIG 5;
FIG. 7 is an enlarged perspective view of a portion B framed by a dashed line in FIG. 6;
FIG. 8A is a plane view of FIG. 7, FIG. 8B is a front view of FIG. 7, and FIG. 8C is a cross-sectional view along a line C-C' in FIG. 8A;
FIG. 9 is a front view showing the engagement between the front panel and the horizontal plate in FIG. 6 being released by a user; and
FIG. 10 is a perspective view of an appearance after engaging a hook portion of a conventional front panel with a chassis in an information reproducing apparatus.

### DESCRIPTION OF THE PREFERRED EMBODIMENTS

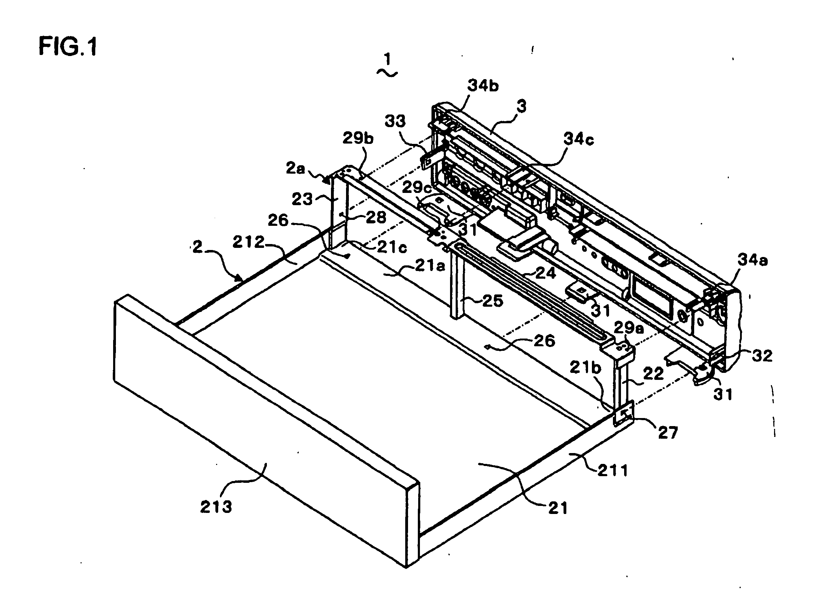

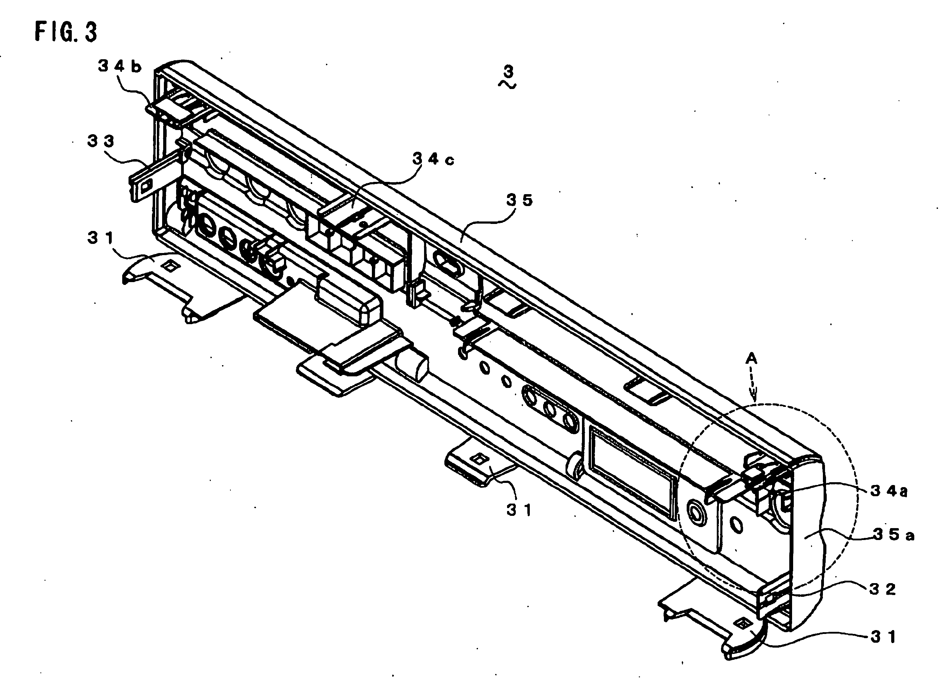

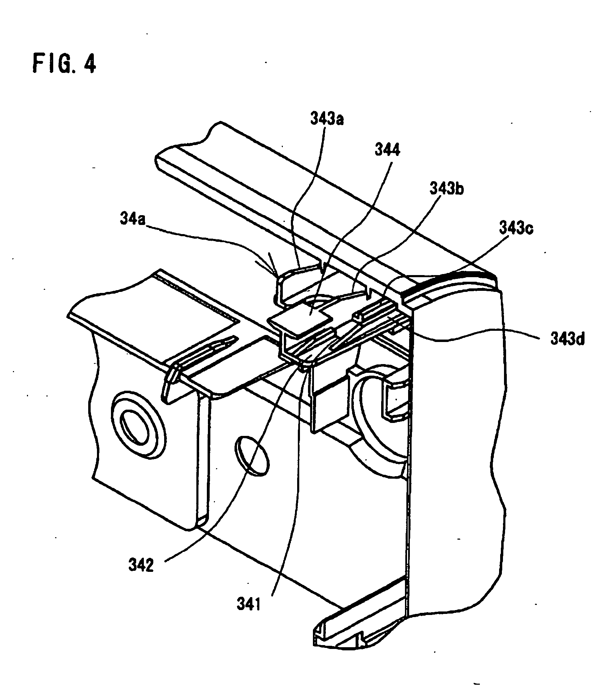

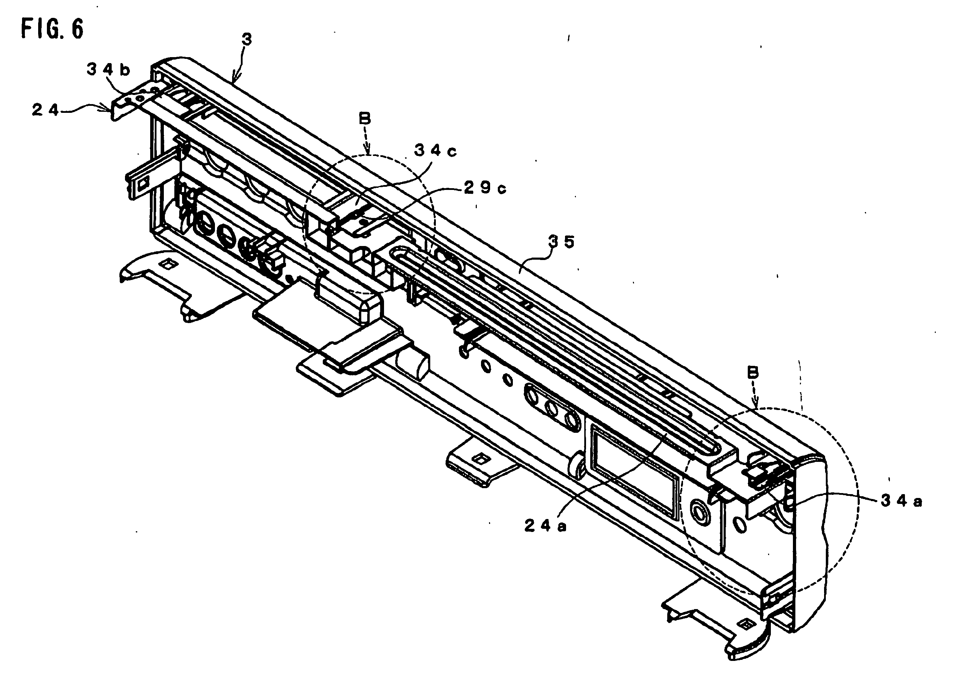

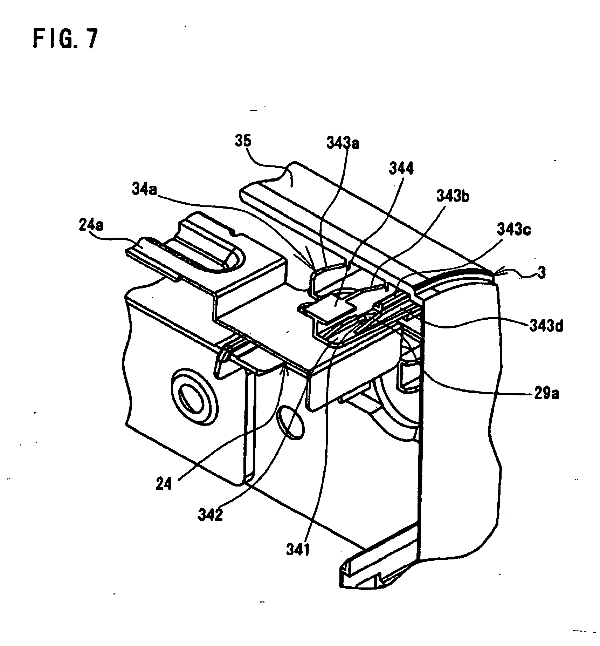

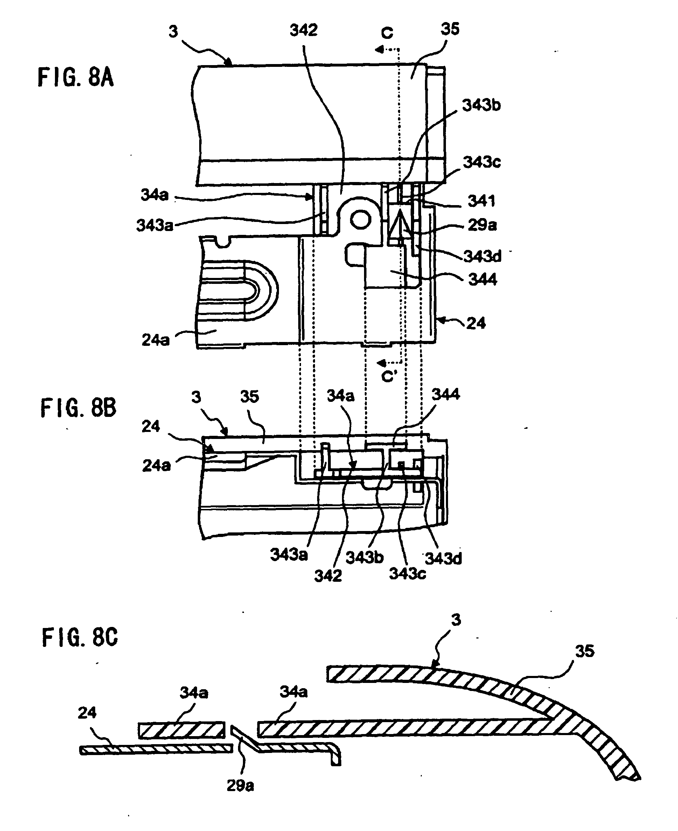

An information reproducing apparatus according to a preferred embodiment of the present invention is described below with reference to FIGS. 1 to 9. FIG. 1 shows a configuration of an information reproducing apparatus 1. The information reproducing apparatus 1 has a reproduction function which enables a reproduction of data such as audios and videos which are stored in a record medium and a recording function which enables storage of the data in the record medium. The record medium includes a video tape, CD, DVD, HDD, or the like. The information reproducing apparatus 1 which has the above functions comprises a chassis 2, a front panel 3 which is attached to a front surface of the chassis 2, drives (not shown) such as a video drive, a CD drive, a DVD drive, a HDD drive, and so on which are mounted in the chassis 2, and a top cover (not shown) which covers the chassis 2 and the drives.

Next, components of the information reproducing apparatus 1 are described in detail. The chassis 2 includes a bottom plate 21, supporting members 22 and 23 which extend perpendicularly from both end portions 21b and 21c of a front end portion 21a in the bottom plate 21, and a horizontal plate 24 which is disposed between the supporting members 22 and 23 and is supported by the supporting members 22 and 23. The supporting member 22 extends perpendicularly from the end portion 21b which is located on a right side in a direction from the chassis 2 toward the front panel 3, and the supporting member 23 extends perpendicularly from the end portion 21c on a left side. The horizontal plate 24 is supported by the supporting member 25 which is located in a substantial center between the supporting members 22 and 23 which also support the horizontal plate 24.

The bottom plate 21 is made up of a sheet metal member. The sheet metal member which constitutes the bottom plate 21 bends at the front end portion 21a in the bottom plate 21 in a staircase pattern. Engaging pawls 26 which project from the front end portion 21a are provided on the front end portion 21a. The engaging pawls 26 are formed by carrying out a plastic deformation on a portion of the bottom plate 21 through a sheet metal processing so as to engage with the front panel 3. A cross-sectional surface of the engaging pawl 26 has a triangular shape, for example, and an apex of the triangle is formed to get higher toward an inward of the information reproducing apparatus 1. The engaging pawls 26 having such a configuration are respectively provided between the supporting members 22 and 25 and between the supporting members 25 and 23, for example.

The sheet metal member which constitutes the bottom plate 21 bends at both end portions of the bottom plate 21 in a substantial L-shaped pattern and thereby forms sidewalls 211 and 212. The sidewall 211 is formed in an end portion which is located on a right side in the direction from the chassis 2 toward the front panel 3, and the sidewall 212 is formed in an end portion on a left side. An engaging pawl 27 projects from a lateral portion of the sidewall 211. The engaging pawls 27 are formed by carrying out a plastic deformation on a portion of the sidewall 211 through a sheet metal processing, and their shapes are substantially similar to the engaging pawl 26 which is formed on the front end portion 21a. Moreover, the sheet metal member bends at a back-end of the bottom plate 21 in a substantial L-shaped pattern and thereby forms a back wall 213.

The supporting members 22 and 25 are made up of prismatic members of injection-molded resin and have projections to determine a position of the horizontal plate 24 on their upper surface, respectively. In contrast, the supporting member 23 is made up of a sheet metal member. An upper portion of the supporting member 23 bends inward of the information reproducing apparatus 1, and a lower portion is screwed and fixed to an inside of the sidewall 212 of the bottom plate 21. An engaging pawl 28 projects laterally from an upper side of the fixed portion of the supporting member 23 to the sidewall 212. The engaging pawl 28 is formed by carrying out a plastic deformation on a portion of the supporting member 23 through a sheet metal processing, and its shape is substantially similar to the engaging pawl 27 which is formed on the sidewall 211.

The horizontal plate 24, which is made up of a sheet metal member, has holes to determine its position, and the projections of the supporting members 22 and 25 are inserted into the holes. The position of the horizontal plate 24 is determined according to the layout of the holes. The horizontal plate 24 is screwed and fixed to the upper portion of the supporting member 23 which bends inward and the upper surfaces of the respective supporting members 22 and 25. Moreover, the horizontal plate 24 has engaging pawls 29a, 29b, and 29c which project upward. The engaging pawls 29a, 29b, and 29c are formed by carrying out a plastic deformation on a portion of the horizontal plate 24 through a sheet metal processing, and their shapes are substantially similar to the engaging pawl 28 which is formed on the supporting member 23. The engaging pawls 29a, 29b, and 29c are provided in proximity to the portions in the horizontal plate 24 to which the supporting members 22, 23, and 25 are fixed.

The front end portion 21a in the bottom plate 21, the supporting members 22 and 23, and the horizontal plate 24 make up an attaching frame 2a in the chassis 2 to attach the front panel 3. As described above, the engaging pawls 26, 27, and 28 are provided on the front end portion 21a and the sidewall 211 in the bottom plate 21 and on the supporting member 23, respectively, and the engaging pawls 29a, 29b, and 29c are provided on the horizontal plate 24. The front panel 3 includes hook portions 31, 32, 33, 34a, 34b, and 34c (abbreviated as the hook portions 31 and so on hereinafter) which correspond to the number and the respective positions of the engaging pawls 26, 27, 28, 29a, 29b, and 29c (abbreviated as the engaging pawls 26 and so on). The front panel 3 is attached to the attaching frame 2a in the chassis 2 by engaging the hook portions 31 and so on with the engaging pawls 26 and so on in the chassis 2. The components of the attaching frame 2a are not limited to the above.

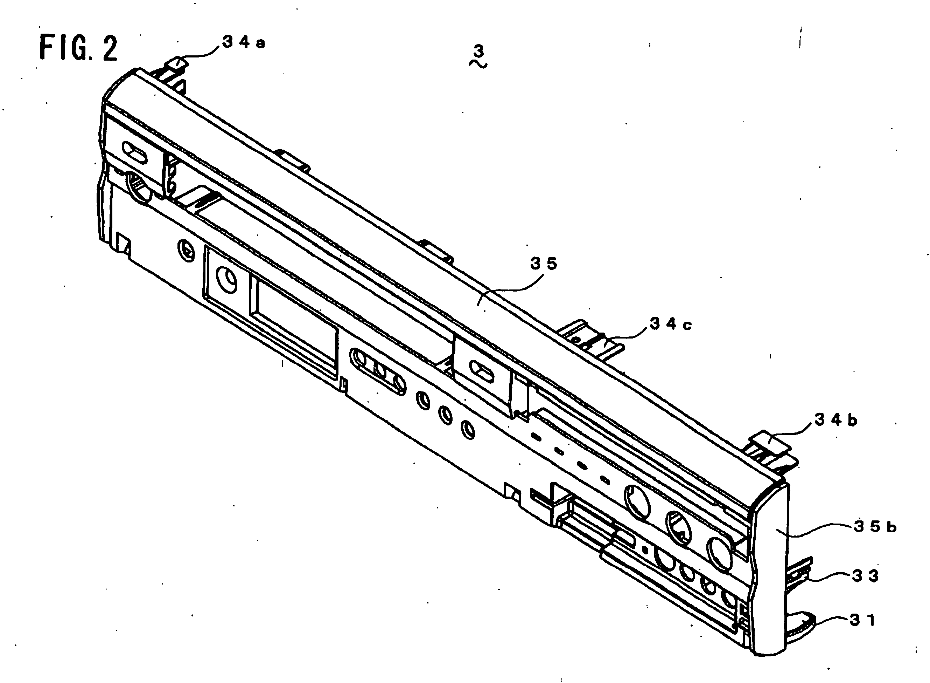

FIGS. 2 to 4 show the configuration of the front panel 3. The front panel 3 is an injection-molded resin member which is formed in a mold, and includes a panel body 35 and the hook portions 31 and so on which extend from a back surface of the panel body 35 toward the inward of the information reproducing apparatus 1. An upper portion and a lower portion of the panel body 35 are curved inward of the information reproducing apparatus 1, and sidewall portions 35a and 35b are provided in the panel body 35 to cover openings of both ends of the panel body 35. The sidewall portion 35a is located in the right side of the panel body 35 when seeing the panel body 35 from the back, and the sidewall portion 35b is located in the left side of the panel body 35 when seeing the panel body 35 from the back. Various openings and holes are provided in the panel body 35, and the openings and holes include openings to insert and eject a video tape, CD, and DVD into/ from the information reproducing apparatus 1, holes and openings which correspond to operation buttons and operation panels, and holes to connect input-output terminals to the information reproducing apparatus 1.

The positions of the hook portions 31 and so on in the front panel 3 are specifically described hereinafter. The hook portions 34a, 34b, and 34c are provided in the curved portion in the upper portion of the panel body 35. The hook portion 31 is provided in a lower surface of the curved portion in the lower portion of the panel body 35. The hook portion 32 is provided in the right end of the panel body 35 when seeing the panel body 35 from the back, and the hook portion 33 is provided in the left end of the panel body 35 when seeing the panel body 35 from the back. The hook portions 31 and so on correspond to the number and the positions of the engaging pawls 26 and so on in the chassis 2 (not shown in FIGS. 2 to 4), respectively. The positions of the hook portions 31 and so on are not limited to the above.

Next, a shape of the hook portions 31 and so on is described. The hook portions 31 and so on are platy projecting portions which include engaging holes in which the engaging pawls 26 and so on in the chassis 2 are inserted when the front panel 3 engages with the chassis 2, respectively. In these platy projecting portions, the hook portions 31, 34a, 34b, and 34c are located along the horizontal direction, and the hook portions 32 and 33 are located along the vertical direction. Moreover, reinforcement ribs are formed on the surfaces of the respective projecting portions. The shape of the hook portion 34a in the hook portions 31 and so on is described in detail hereinafter.

The hook portion 34a includes a projecting portion 342 which extends inward of the information reproducing apparatus 1 horizontally and has an engaging hole 341, four ribs 343a, 343b, 343c and 343d of which two are formed on both ends of the projecting portion 342 and remaining two are formed between the both ends of the projecting portion 342 on an upper surface side of the projecting portion 342, and a finger hook portion 344 which is provided on an upper end of one rib 343b which is formed between the both ends of the projecting portion 342 and extends in a direction toward both laterals of the projecting portion 342 horizontally to hook tips of fingers. The projecting portion 342, the ribs 343, and the finger hook portion 344 are formed to be integral with each other. A portion of the projecting portion 342 is cut off to let out a projection on the upper surface of the supporting member 22 which is inserted into the hole in the horizontal plate 24 to determine the position of the horizontal plate 24 and also to let out a screw which fixes the horizontal plate 24 on the supporting member 22. A tip of a bottom surface of the projecting portion 342 is formed in a tapered shape. The ribs 343 reinforce the projecting portion 342.

The finger hook portion 344 is provided on the rib 343 which is closer to a center of the projecting portion 342 in a width direction in the two ribs 343 which are formed between the both ends of the projecting portion 342. The finger hook portion 344 is formed on a portion of the upper end of the rib 343 in continuity. The finger hook portion 344 is substantially stable in width, and the width of the finger hook portion 344 is smaller than a width of the projecting portion 342, and its thickness is substantially the same as the width of the rib 343. Moreover, the finger hook portion 344 is located between the upper surface and the lower surface of the upper end of the curved portion in the upper portion of the panel body 35 in a height direction. The engaging hole 341 goes through the projecting portion 342 and the rib 343 on which the finger hook portion 344 are not provided in the two ribs 343 which are formed between the both ends of the projecting portion 342.

According to the above configuration, the finger hook portion 344 extends horizontally, so that it is easy to hook the fingers. Moreover, the finger hook portion 344 is integrally formed along the rib 343, so that a strong force is not necessary to remove the mold during the production of the front panel 3. Consequently, whitening does not occur on the front panel 3 due to the formation of the finger hook portion 344. The finger hook portion 344 is formed on the upper end of the rib 343 to be integral with the rib 343 and is located between the upper surface and the lower surface of the upper end of the curved portion in the upper portion of the panel body 35 in the height direction, so that it is also easy to make the mold of the front panel 3 which has the finger hook portion 344. Moreover, the thickness of the finger hook portion 344 and the width of the rib 343a, 343b, 343c and 343d are substantially the same, so that there is a small chance of an occurrence of a surface sink on the rib 343a to 343d and the finger hook portion 344 itself due to the formation of the finger hook portion 344 during the production of the front panel 3. Furthermore, the openings, the holes, and so on are not necessary when the finger hook portion 344 is formed, so that a weld line does not occur on the front panel 3 due to the formation of the finger hook portion 344.

Besides, the shape of the finger hook portion 344 is not limited to the above, however, any shape is applicable as long as it has a shape or a size large enough to be hooked by the fingers. The finger hook portion 344 may also be formed on the whole upper end of the rib 343b in continuity instead of on the portion of the upper end of the rib 343b in continuity. When the finger hook portion 344 is formed on the whole upper end of the rib 343b in continuity, the finger hook portion 344 may extend from the back surface of the panel body 35 together with the rib 343b. When the finger hook portion 344 is formed in this manner, the width of the rib 343b is smaller than the thickness of the panel body 35, and the thickness of the finger hook portion 344 is substantially the same as the width of the rib 343b, thus the occurrence of the surface sink on the surface of the panel body 35 due to the formation of the finger hook portion 344 can be avoided.

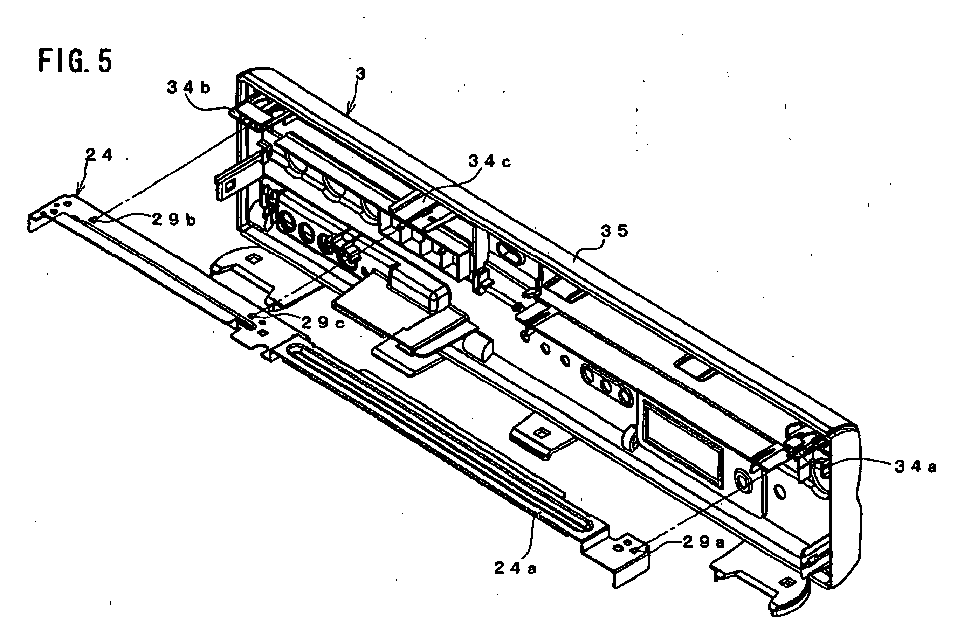

FIGS. 5, 6, 7, 8A, 8B, and 8C show appearances before and after the hook portions 34a, 34b, and 34c (abbreviated as "the hook portions 34a and so on" hereinafter) on the front panel 3 engage with the engaging pawls 29a, 29b, and 29c (abbreviated as "the engaging pawls 29a and so on" hereinafter) which are provided on the horizontal plate 24 in the chassis 2. In these diagrams, the bottom plate 21 and the supporting members 22, 23, and 25 in the chassis 2 are omitted. The horizontal plate 24 has a top cover supporting portion 24a which is bended to be one step higher than the area near the engaging pawl 29a.

The hook portions 34a and so on are located in the positions to correspond to the engaging pawls 29a and so on in the horizontal plate 24, respectively. When the front panel 3 engages with the chassis 2, the hook portions 34a and so on are disposed on the upper side of the engaging pawls 29a and so on. The engagement between the hook portion 34a and the engaging pawl 29a is described in detail hereinafter.

A cross-sectional surface of the engaging pawl 29a which engages with the hook portion 34a has a triangular shape, for example, and an apex of the triangle is formed to get higher in height from an a portion closer to the front panel 3 toward the inward of the information reproducing apparatus 1. When the front panel 3 engages with the chassis 2, the bottom surface of the projecting portion 342 has a direct contact with the engaging pawl 29a and has a slide starting from its tip to the engaging pawl 29a. The tip of the bottom surface of the projecting portion 342 is formed in the tapered shape, and in the engaging pawl 29a, the portion closer to the front panel 3 is lowest in height, and the engaging pawl 29a becomes higher gradually as it gets closer to the inward of the information reproducing apparatus 1, so that the hook portion 34a can easily be attached to the engaging pawl 29a while contacting the engaging pawl 29a. As the portion which has a direct contact with the engaging pawl 29a in the projecting portion 342 moves toward the panel body 35, the projecting portion 342 bends upward. Subsequently, the engaging pawl 29a is inserted into the engaging hole 341 in the projecting portion 342 from below. In this manner, the projecting portion 342 and the engaging pawl 29a engage with each other.

When the projecting portion 342 and the engaging pawl 29a engage with each other, the projecting portion 342 and the top cover supporting portion 24a are located close to each other, and the top cover supporting portion 24a and the front panel body 35 are located close to each other, so that it is hard to put the finger in spaces surrounded by them. Moreover, the projecting portion 342 and the horizontal plate 24 are close to each other, so that it is hard to put in the finger between the projecting portion 342 and the horizontal plate 24. The tip of the bottom surface of the projecting portion 342 is formed in the tapered shape, however, the projecting portion 342 is thin enough to bend, so that even the tapered tip of the bottom surface of the projecting portion 342 is not of so much help to put in the finger between the tip of the projecting portion 342 and the horizontal plate 24.

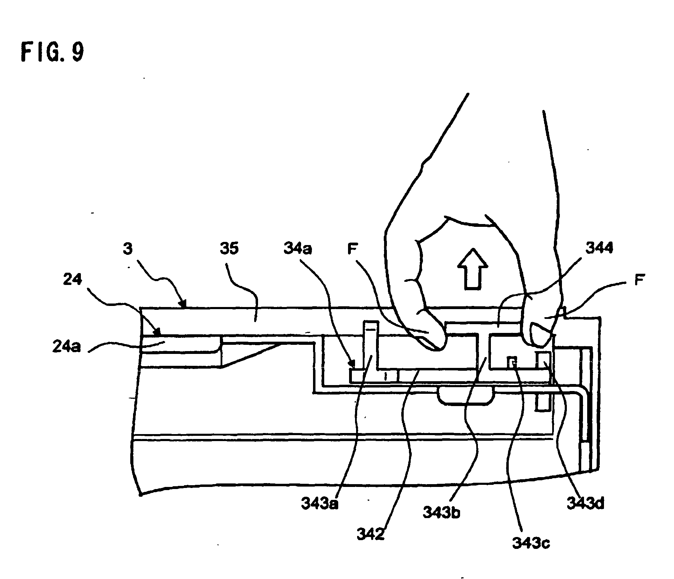

FIG. 9 shows an appearance of the front panel 3 and the horizontal plate 24 in the chassis 2 whose engagement is released by a user, and more particularly, an appearance of the hook portion 34a in the front panel 3 and the engaging pawl 29a on the horizontal plate 24 whose engagement is released.

In the present preferred embodiment, the finger hook portion 344 is provided on the upper end of the rib 343, so that when the user hooks tips of fingers F on the finger hook portion 344 and subsequently pinches and picks up the right side and the left side of the finger hook portion 344, the engagement between the hook portion 34a and the engaging pawl 29a can easily be released. Consequently, the front panel 3 can easily be detached from the chassis 2. Moreover, the finger hook portion 344 is provided on the upper end of the rib 343b which is formed between the both ends of the projecting portion 342 and has the width narrower than the projecting portion 342, so that the user can pinch the finger hook portion 344 without being interfered by the members such as the top cover supporting portion 24a, for example, which is located close to the lateral of the hook portion 34a. Consequently, the front panel 3 can easily be detached from the chassis 2.

The present invention is not limited to the composition of the preferred embodiment described above, however, various modification are applicable in accordance with the intended use. For example, the number of the engaging pawls 26, 27, and 28 and the engaging pawls which are formed on the horizontal plate 24 is not limited to the number of the engaging pawls shown in the diagrams, however, any number of the engaging pawls is applicable. Moreover, a panel which has a configuration similar to the front panel 3 can be attached not only to the front surface of the information reproducing apparatus 1 but also to the side surface or the back surface of the information reproducing apparatus 1. Furthermore, the hook portions 34a and so on can be provided not only on the upper portion of the panel body 35 but also on the lower portion of the panel body 35, the sidewall portions 35a or 35b, or on the area near the lower portion of the panel body 35.

This application is based on Japanese utility model application 2006-8703 filed October 25, 2006.

## Claims

1. An information reproducing apparatus (1) comprising:
a chassis (2) which has an engaging pawl (29a) which projects upward; and
a front panel (3) which is attached to a front surface of the chassis (2),
wherein the front panel (3) has a hook portion (34a) with which the engaging pawl (29a) is engaged, and
wherein the hook portion (34a) includes
a projecting portion (342) which has an engaging hole (341) into which the engaging pawl (29a) is inserted from below, and
ribs (343a, 343b, 343c, 343d) which are formed on both ends of the projecting portion (342) and between the both ends of the projecting portion (342) on an upper surface side of the projecting portion (342),
**characterised in that**
the hook portion (34a) has a finger hook portion (344) which is provided on an upper end of the rib (343b) which is formed between the both ends of the projecting portion (342) and extends in a direction toward both laterals of the projecting portion (342) to release, with the tips of the fingers, the projecting portion (342) from the engaging pawl (29a).

2. The information reproducing apparatus (1) according to claim 1, -
wherein in the case where the engaging pawl (29a) in the chassis (2) is engaged with the engaging hole (341) in the hook portion (34a) on the front panel (3), the front panel (3) is detached from the chassis (2) when a user hooks tips of fingers on a finger hook portion (344) in the hook portion (34a) and subsequently pinches and picks up the finger hook portion (344).

## Patentansprüche

1. Eine informationswiedergebende Vorrichtung (1), umfassend: einen Rahmen (2), der eine nach oben ragende Aufnahmeklinke (29a) aufweist, eine Frontverkleidung (3), die an eine Vorderseite des Rahmens (2) angelenkt ist, wobei die Frontverkleidung (3) einen Hakenbereich (34a) aufweist, mit der die Aufnahmeklinke (29a) verbunden ist, und wobei der Hakenbereich (34a) einen vorstehenden Bereich (342) beinhaltet, der eine Aufnahmeöffnung (341) hat, in die die Aufnahmeklinke (29a) von unterhalb einführbar ist, und Rippen (343a, 343b, 343c, 343d), welche an beiden Enden des vorstehenden Bereiches (342) und zwischen den beiden Enden des vorstehenden Bereiches (342) auf einer oberen Oberseite des vorstehenden Bereiches (342) geformt sind,
**dadurch gekennzeichnet, dass**
der Hakenbereich (34a) einen Fingerhakenbereich (344) aufweist, der auf einem oberen Ende der Rippe (343b) angeordnet ist, die zwischen den beiden Enden des vorstehenden Bereichs (342) geformt ist und sich in Richtung zweier Seitenteilen des vorstehenden Bereiches (342) erstreckt, um den vorstehenden Bereich (342) von der Aufnahmeklinke (29a) mit den Fingerspitzen zu lösen.

2. Die informationswiedergebende Vorrichtung (1) nach Anspruch 1, wobei im Fall, dass die Aufnahmeklinke (29a) mit dem Rahmen (2) in Eingriff steht, über die Aufnahmeöffnung (341) mit dem Hakenbereich (34a) auf der Frontverkleidung (3), die Frontverkleidung (3) von dem Rahmen (2) lösbar ist, wenn ein Benutzer seine Fingerspitzen mit dem Fingerhakenbereich (344) im Hakenbereich (34a) verhakt und daraufhin den Fingerhakenbereich (344) drückt und hochzieht.

## Revendications

1. Appareil de reproduction d'informations (1) comprenant :
un châssis (2) qui présente une patte d'encliquetage (29a) dépassant vers le haut ; et
un panneau avant (3) qui est fixé à une surface avant du châssis (2),
étant précisé que le panneau avant (3) a une partie en forme de crochet (34a) avec laquelle la patte (29a) vient s'encliqueter, et
que la partie en forme de crochet (34a) comprend une partie saillante (342) avec un trou d'encliquetage (341) dans lequel la patte d'encliquetage (29a) est introduite par-dessous, et
des rebords (343a, 343b, 343c, 343d) qui sont formés sur les deux extrémités de la partie saillante (342) et entre les deux extrémités de la partie saillante (342) sur un côté de surface supérieure de la partie saillante (342),
**caractérisé en ce que** la partie en forme de crochet (34a) a une partie d'accrochage pour les doigts (344) qui est prévue sur une extrémité supérieure du rebord (343b) formé entre les deux extrémités de la partie saillante (342) et qui s'étend en direction des deux côtés de celle-ci (342) pour dégager de la patte d'encliquetage (29a) la partie saillante (342) avec la pointe des doigts.

2. Appareil de reproduction d'informations (1) selon la revendication 1, dans lequel au cas où la patte d'encliquetage (29a) prévue dans le châssis (2) est encliquetée dans le trou d'encliquetage (341) prévu dans la partie en forme de crochet (34a) sur le panneau avant (3), le panneau avant (3) s'enlève du châssis (2) quand un utilisateur met la pointe des doigts sur une partie d'accrochage pour les doigts (344) prévue dans la partie en forme de crochet (34a) puis pince et décroche ladite partie d'accrochage pour les doigts (344).
